# EUROPEAN PATENT SPECIFICATION

(11) **EP 3 513 423 B1**
(45) Date of publication and mention of the grant of the patent: **18.11.2020**
(21) Application number: 17768110.3
(22) Date of filing: 14.09.2017
(51) Int. Cl.: H01J 37/32, C23C 16/06, H05H 1/46

(54) **DEVICE AND METHOD FOR PERFORMING ATMOSPHERIC PRESSURE PLASMA ENHANCED CHEMICAL VAPOUR DEPOSITION AT LOW TEMPERATURE**
VORRICHTUNG UND VERFAHREN ZUR DURCHFÜHRUNG VON ATMOSPHÄRENDRUCKPLASMAVERSTÄRKTER CHEMISCHER ABSCHEIDUNG AUS DER DAMPFPHASE BEI NIEDRIGER TEMPERATUR
DISPOSITIF ET MÉTHODE POUR RÉALISER UN DÉPÔT CHIMIQUE EN PHASE VAPEUR ASSISTÉ PAR PLASMA À PRESSION ATMOSPHÉRIQUE À BASSE TEMPÉRATURE

(30) Priority: 15.09.2016 LU 93221
(43) Date of publication of application: 24.07.2019
(73) Proprietor: Luxembourg Institute of Science and Technology (LIST), 4362 Esch-sur-Alzette (LU)
(72) Inventor: BABA, Kamal, 2533 Luxembourg (LU); BOSCHER, Nicolas, 57390 Audun le Tiche (FR); BULOU, Simon, 57070 Metz (FR); CHOQUET, Patrick, 57050 Longeville lès Metz (FR); GERARD, Mathieu, 54720 Cutry (FR); QUESADA GONZALEZ, Miguel, 4367 Belvaux (LU)
(74) Representative: Lecomte & Partners
(86) International application number: PCT/EP2017/073165
(87) International publication number: WO 2018/050758

(56) References cited:
- GB-A- 2 245 600
- JP-A- 2006 324 146
- US-A1- 2007 212 486
- SCHLUTER ET AL: "Travelling-wave-sustained discharges", PHYSICS REPORTS, NORTH-HOLLAND, AMSTERDAM, NL, vol. 443, no. 4-6, 9 May 2007 (2007-05-09) , pages 121-255, XP022067026, ISSN: 0370-1573, DOI: 10.1016/J.PHYSREP.2006.12.006 cited in the application

## Description

### Technical field

The present invention lies in the field of surface treatment and deposition of functional transition metal oxide coatings. More particularly, the invention is directed to the field of atmospheric pressure plasma enhanced chemical vapour deposition on heat-sensitive substrate at low temperature. A post-discharge plasma device is disclosed as well as the method employing such device.

### Background art

Atmospheric pressure plasma enhanced chemical vapour deposition of metal oxide on substrate is usually performed at high temperatures in order to obtain crystalline coatings.

US patent application published US 2007/0212486 A1 discloses method of plasma enhanced chemical vapour deposition of metal oxide, notably of zinc oxide, on plastic substrate. The plastic is maintained at a temperature near its glass-transition temperature (T_{g}), preferably at a temperature not exceeding 50°C. The method is carried out at or near atmospheric pressure (760 Torr), typically in the range of 700-800 Torr. However, the chemical vapour deposition is performed thanks to a corona discharge or thanks to a dielectric barrier discharge.

Furthermore, GB 2 245 600 A discloses a plasma post-discharge deposition device and JP 2006 324146 A discloses an atmospheric pressure microwave plasma reaction device to treat fibres or fabrics.

The work of Davis M. J. et al., entitled "Atmospheric-pressure plasma-enhanced chemical vapour deposition (AP-PECVD) for growth of thin films at low temperature" used an audio-frequency glow discharge plasma reactor in order to deposit thin film of titanium dioxide on glass and plastic. They have obtained a granular film with grain sizes ranging from about 50-300 nm. However, XRD (X-Ray Diffraction) analysis shows that the deposited films are amorphous.

### Summary of invention

### Technical Problem

The invention has for technical problem to alleviate at least one of the drawbacks present in the prior art.

In particular, the invention proposes a solution to deposit a crystalline coating onto heat-sensitive substrate.

### Technical solution

The first object of the invention is directed to a plasma post-discharge deposition device for depositing crystalline metal oxide derivative on a substrate according to claim 1. Said plasma post-discharge deposition device is remarkable in that said central zone is located at a distance comprised between 1 mm and 2.5 mm from the internal surface of said dielectric tube.

According to a preferred embodiment, said central zone has a temperature inferior or equal to 150°C configured for activating the surface of a substrate-to-be-coated, preferably a temperature inferior to 100°C.

According to a preferred embodiment, said dielectric tube is a discharge tube in quartz, Pyrex™, alumina, silica, or any dielectric material, preferentially in quartz.

According to a preferred embodiment, said surface wave launcher is a microwave surface wave launcher with a frequency comprised between 300 MHz and 300 GHz, preferentially with a frequency of 2.45 GHz.

According to a preferred embodiment, said post-discharge deposition chamber is located at a distance comprised between 0.5 cm and 20 cm from said surface wave launcher, preferentially at a distance of 6 cm.

According to a preferred embodiment, said gas source is configured to inject a gas into said surface wave launcher, said gas being preferentially argon, helium, krypton, xenon, nitrogen, hydrogen, oxygen and/or any combination thereof.

According to a preferred embodiment, said device further comprises a chemical precursor source placed in the post-discharge region of the device and configured to deliver a chemical precursor onto the plasma-activated surface of a substrate, said chemical precursor being preferentially a crystalline metal oxide derivative precursor, more preferentially a crystalline metal oxide derivative precursor mixed-up with pre-formed metallic nanoparticles and/or mixed-up with a chemical precursor for doping.

According to a preferred embodiment, said chemical precursor source is connected to an atomising arrangement configured to deliver a chemical precursor in the form of a mist and/or an aerosol, said atomising arrangement being preferentially an ultrasonic system.

According to a preferred embodiment, said gas source further comprises a metal nanoparticles precursor delivery system configured to deliver metal nanoparticles precursor into said gas, said metal nanoparticles precursor being more preferentially silver, palladium, platinum or gold nanoparticles precursor.

The second object of the invention is directed to a plasma-enhanced chemical vapour deposition method, comprising the steps of (a) activating a substrate in a plasma post-discharge deposition device so as to produce a plasma-activated substrate; and (b) functionalizing said plasma-activated substrate by a reagent in the post-discharge zone of said plasma post-discharge deposition device. Said method is remarkable in that said plasma post-discharge deposition device is a plasma post-discharge deposition device in accordance with the first object of the invention.

According to a preferred embodiment, said plasma-enhanced chemical vapour deposition is carried out at atmospheric pressure and/or at a temperature which is inferior or equal to 150°C, preferably a temperature inferior to 100°C.

According to a preferred embodiment, said substrate is a heat-sensitive substrate.

According to a preferred embodiment, said substrate is a one-dimensional substrate or a two-dimensional substrate.

According to a preferred embodiment, said reagent is a crystalline metal oxide derivative, preferentially TiO₂, ZnO, WO₃, or a doped crystalline metal oxide derivative, preferentially TiO₂ doped with boron, or a mixture of metallic nanoparticles with a crystalline metal oxide derivative.

In general, the particular embodiments of each object of the invention are also applicable to other objects of the invention. Each object of the invention can also be combined with other objects of the invention insofar as possible.

### Advantages of the invention

The invention is particularly interesting in that the deposition of the metal oxide derivative can be achieved on heat-sensitive substrates, such as polymers, plastics and/or glass, without deteriorating those substrates. The deposited metal oxide layers are crystalline and the coating by itself can be achieved at a temperature inferior to 150°C, even inferior to 100°C. The crystallinity of the coated layers permits the use of those coated surfaces in photocatalytic, photovoltaic or sensing applications.

Moreover, due to the tubular configuration of the reactor, the coating of one-dimensional substrates, such as, for example optical fibres with layers of crystalline metal oxide derivatives, is allowed.

### Brief description of the drawings

Figure 1: Experimental set-up in accordance with the first embodiment of the present invention.
Figure 2: Schematic representation of plasma generation in a microwave discharge at atmospheric pressure.
Figure 3: Cross-section of the scheme of figure 2 at the exit of the electromagnetic surface wave launcher.
Figure 4: Experimental set-up in accordance with the second embodiment of the present invention.
Figure 5: SEM images of TiO₂ film deposited on optical fibre using titanium ethoxide. (a) Top view (b) cross section.
Figure 6: Raman spectrum of TiO₂ thin films on Si substrate as function of O₂/Ar ratio.
Figure 7: Raman spectrum of TiO₂ thin films on PMMA optical fibre using TEOT. The Raman spectrum of the PMMA fibre without coating is also provided as a reference.
Figure 8: XPS spectra of B 1s in the B/TiO₂ film. (a) Surface spectrum and (b) bulk spectrum obtained by in-depth profiling.
Figure 9: Raman Spectrum of B/TiO₂ film on silicon wafer substrate.
Figure 10: SEM image of B/TiO₂ film on silicon wafer substrate.
Figure 11: Backscattering SEM images on Ag-TiO₂ composite coating deposited on silicon substrate (a) and the corresponding EDS spectrum and chemical composition.
Figure 12: UV-visible absorption spectra of TiO₂ and Ag-TiO₂ coatings deposited on glass substrate.
Figure 13: Single Ag nanoparticles synthesised by the process of the invention.
Figure 14: Schematic of the set up used to synthesise simultaneously Au NPs embedded in anatase TiO₂ coating using two different liquid precursors injected by two different nebulizing systems.
Figure 15: XRD pattern of Au NPs@anatase TiO₂. Au metallic NP are about 15 nm diameter and TiO₂ anatase grain are about 25 nm diameter according to Scherrer's formula.
Figure 16: Au 4f and Ti 2p XPS peaks. Results shows only metallic Au and stoichiometric TiO₂ (only Ti⁴⁺ bonding, no Ti³⁺).
Figure 17: UV-Visible absorption spectra of Au NPs@anatase TiO₂ exhibiting the characteristic plasmon resonance absorption peak (500-600 nm).
Figure 18: Picture of glass substrate coated with Au NPs@anatase TiO₂ exhibiting the characteristic pink color due to Au NP plasmon resonance.

### Description of an embodiment

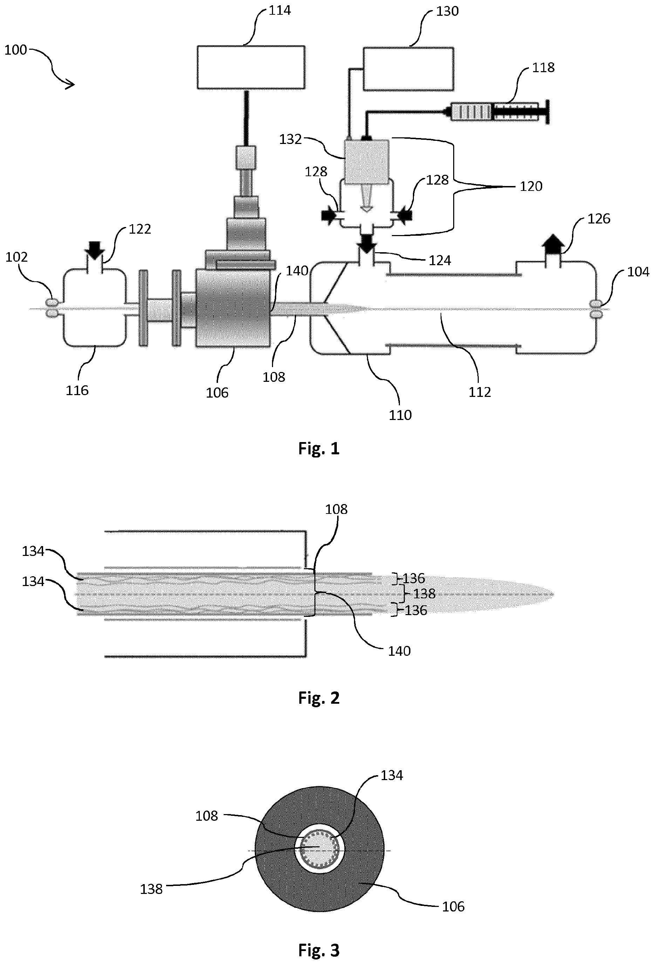

Figure 1 represents the experimental device 100 in accordance with the first embodiment of present invention.

The device 100 comprises a substrate inlet 102, which is configured for introducing a substrate 112. Said substrate 112 goes through the system composed of a surface wave launcher 106, or an electromagnetic surface wave launcher, and a dielectric tube 108. Once said substrate 112 has been activated by the plasma, or plasma-activated, it goes through the deposition chamber, or post discharge chamber 110, where the plasma excited species, the chemical precursor and the substrate surface react to produce a coating on the substrate surface. Once the reaction has been performed, the coated substrate 112 is picked up in the substrate outlet 104.

The post-discharge zone of the device 100 is located beyond the launching gap 140 of the electromagnetic surface wave launcher 106 in the side of the deposition chamber 110.

As it is apparent on figure 1, the substrate inlet 102 and the substrate outlet 104 define a longitudinal central axis which has the general direction of the substrate 112. The dielectric tube 108 is inserted between the substrate inlet 102 and the deposition chamber 110 on said longitudinal central axis for the reasons that will be apparent below, and goes through the microwave surface wave launcher.

The surface wave launcher 106 is preferentially an electromagnetic surface wave launcher of the type Surfatron.

Nevertheless, it is to be understood that any microwave system able to ignite and sustain plasma at atmospheric pressure might be employed. For example, Beenakker resonator, surfaguide, metallic microwave plasma torches or semi-metallic microwave plasma torches might be employed.

The frequency of the microwave surface wave launcher is comprised between 300 MHz and 300 GHz.

The tube 108 is a dielectric tube that is designed for confining the plasma discharge generated by the electromagnetic surface wave launcher 106. This dielectric tube 108 is also called the discharge tube and is low loss, high temperature-resistant dielectric such as fused silica, quartz, Pyrex™, ceramic, alumina or silica, preferentially in quartz. The distal end of the discharge tube 108 ends inside a deposition chamber 110. Said post-discharge deposition chamber 110 is therefore located in the post-discharge region of the device 100 at a distance between 0.5 cm and 20 cm from the said electromagnetic surface wave launcher (106; 206), preferentially at a distance of 6 cm.

The inner diameter of the discharge tube 108 is comprised between 1 and 100 mm, preferably 5 mm.

The outer diameter of the discharge tube 108 is comprised between 3 mm and 103 mm, preferably 7 mm.

The electromagnetic surface wave launcher 106 is working thanks to its connection with a power supply 114. When Surfatron is used, the frequency of the power supply 114 is comprised between 2.43 GHz and 2.47 GHz, preferably equal to 2.45 GHz. It operates in continuous mode with a power comprised between 20 and 300 W, preferably 200 W.

The electromagnetic surface wave launcher 106 is used to produce the surface-wave discharge by application of a high-frequency electric field. The discharge is generated at atmospheric pressure inside the discharge tube 108.

In order to generate the plasma, the electromagnetic surface wave launcher 106 must be connected to a gas source 116. The arrow at the inlet 122 of the gas source 116 on figure 1 merely indicates the direction of the flow of the gas. Any non-condensable gas or mixture such as Ar, He, Kr, Xe, N₂, H₂, O₂ or any combination of aforementioned gases, preferentially Ar, is injected into the electromagnetic surface wave launcher 106 in order to be ionized and to thus generate plasma jet inside the said discharge tube (108 ; 208) that will activate the substrate 112 and/or reacts with a chemical precursor.

The gas flow at the gas source 116 is comprised between 1 and 100 standard litres per minute (slm), more preferentially 10 slm by a flow controller (not shown).

The following part of the description will describe the arrangement designed for delivering the chemical precursor onto the plasma-activated substrate 112.

The deposition chamber 110 in the post-discharge region of the device 100 is configured to receive the distal end of the discharge tube 108.

Additionally to the substrate outlet 104, the (post-discharge) deposition chamber 110 comprises an inlet 124 and an outlet 126.

The outlet 126 is used as an exhaust of the deposition chamber 110.

A chemical precursor source 118 present under the form of a solid, liquid or gaseous source, preferentially liquid, is injected in the post-discharge region of the device 100 and reacts with plasma-excited gas species to synthesise a coating on the substrate surface.

Said chemical precursor, preferentially in a liquid form, may be under the form of a mist and/or an aerosol. For this, it may pass through an atomising arrangement 120 that is located between the chemical precursor source 118 and the (post-discharge) deposition chamber 110.

The atomising arrangement 120 is preferentially an ultrasonic system.

The ultrasonic system comprises an ultrasonic nozzle 132 adapted for spraying the chemical precursor into a mist and/or an aerosol that will be carried into the (post-discharge) deposition chamber 110 and on the plasma-activated substrate 112 with carrier gases, such as argon and/or oxygen. The flow of the carrier gas is comprised between 0.1 and 10 slm, preferably 1 slm and is indicated on figure 1 by the arrows 128.

The ultrasonic system 120 is working thanks to an ultrasonic generator 130, preferentially an ultrasonic generator from Sono-Tek that operates at a frequency of 120 kHz.

The mist and/or the aerosol are generally composed of droplets with diameters ranging between 1 µm and 100 µm, preferably between 10 µm and 20 µm.

The chemical precursor can be a metal precursor.

The metal precursor can be any metal precursor, preferentially a metal halide, a metal nitrate or any organometallic compounds.

The metal precursor can be any metal precursor, preferentially a titanium precursor, a tungsten precursor, a zirconium precursor, a zinc precursor, a vanadium precursor, a hafnium precursor, a tantalum precursor, a molybdenum precursor or a niobium precursor.

An example of commonly used titanium precursor is titanium ethoxide (Ti(OC₂H₅)₄).

Titanium(IV) isopropoxide (TTIP), (Ti[OCH(CH₃)₂]₄), titanium(IV) chloride (TiCl₄), titanium(IV) butoxide (Ti(OCH₂CH₂CH₂CH₃)₄), titanium diisopropoxide bis(acetylacetonate) ([(CH₃)₂CHO]₂Ti(C₅H₇O₂)₂) or titanium ethoxide (Ti(OC₂H₅)₄) can be used to deposit a crystalline layer of TiO₂ for photocatalysis, self-cleaning surfaces or gas sensing applications.

Tungsten hexaphenoxide (W(OPh)₆), tungsten hexacarbonyl (W(CO)₆), or tungsten(VI) chloride (WCl₆) can be used to deposit a crystalline layer of WO₃ for water splitting or gas sensing applications.

Zirconium acetylacetonate (Zr(acac)₄), zirconium(IV) acetate or zirconium(IV) chloride (ZrCl₄) can be used to deposit a crystalline layer of ZrO₂ for fuel cells, gas sensing, catalysis or antimicrobial coatings applications.

Zinc acetate ((CH₃CO₂)₂Zn), zinc acetylacetonate (Zn(acac)₂) or zinc chloride (ZnCl₂) can be used to deposit a crystalline layer of ZnO for gas sensing, photocatalysis, piezoelectric transducers or light-emitting devices.

Vanadium(V) oxytripropoxide (VO(OCH₂CH₂CH₂CH₃)₃), vanadium (III) acetylacetonate (V(C₅H₇O₂)₃), vanadium(IV)-oxyacetylacetonate (OV(C₅H₇O₂)₂) or vanadium(III) chloride (VCl₃) can be used to deposit a crystalline layer of V₂O₅ as electrochemical capacitors or cathode for rechargeable lithium ion batteries.

Hafnium(IV) chloride (HfCl₄) or hafnium(IV) oxychloride (HfOCl₂) can be used to deposit a crystalline layer of HfO₂ for gas sensing, protective coatings, anti-reflection coatings and dielectric materials applications.

Tantalum(V) ethoxide (Ta(OC₂H₅)₅) can be used to deposit a crystalline layer of Ta₂O₅ for gas sensing, anti-reflection coatings or piezoelectric materials.

Molybdenum hexacarbonyl (Mo(CO)₆) can be used to deposit a crystalline layer of M0O₃ for photocatalysis, gas sensing or capacitors applications.

Niobium(V) chloride (NbCl₅) can be used to deposit a crystalline layer of Nb₂O₅ for gas sensing, anti-reflection coatings or piezoelectric applications.

Alternatively, the metal precursor can be doped, for example with boron for TiO₂, molybdenum for WO₃, manganese for ZrO₂ and aluminium for ZnO.

Suitable chemical precursors for the doping of TiO₂ with boron can be used. It aims to enhance the photocatalytic properties and to expand the response of TiO₂ anatase to visible light region of the spectrum. Such boron derivatives could be triethyl borate ((C₂H₅O)₃B) and/or trimethyl borate (B(OCH₃)₃). Trimethyl borate can be advantageously used in order to reduce the formation of powder due to its poor reactivity.

Boric acid (H₃BO₃) has been reported previously as a convenient boron precursor for the deposition of doped TiO₂ thin films, stimulating the growth of larger agglomerations of TiO₂ crystals by generating a more acidic pH when the reaction takes place.

Triethyl borate ((C₂H₅O)₃B) and TTIP, which can be used to grow boron-doped TiO₂ thin films with enhanced conductivity can be used.

TiCl₄ and trimethyl borate (B(OCH₃)₃, which can be employed to grow boron-doped TiO₂ for enhanced photocatalytic activity can be used.

Boric acid (H₃BO₃) and titanium tetraethoxide, which can be employed for the deposition of boron-doped TiO₂ thin films in terms of enhancing the photoactivity and the visible light response of TiO₂ can be used.

Nitrogen has been proved to be an effective dopant for TiO₂ thin films. The doping with nitrogen by AP-PECVD in the reactor, could be carried out by injecting a small flow of nitrogen gas through the plasma generating gas (Ar, in this case), and by changing the amount of N₂ gas which is injected, different concentrations of the dopant can be achieved for the synthesis of N-TiO₂ thin films.

TTIP and NH₃ as a reactive doping gas can be used for the growth of N-doped TiO₂ thin films for visible light photocatalytic activity.

Tungsten ethoxide [W(OEt)₆] and TTIP for the deposition tungsten-doped TiO₂ coatings with enhanced photocatalytic and opto-electrical properties can be used.

Vanadium tetrachloride (VCl₄) or vanadyl acetylacetonate [C₁₀H₁₄O₅V] and titanium butoxide (TBOT) can be used for the synthesis of vanadium-doped TiO₂ for visible-light photocatalysis.

Cr- or Fe-ion-doped TiO₂ for enhanced water splitting performances can be grown by titanium butoxide [Ti(OC₄H₉)₄] and chromium nitrate [Cr(NO₃)₃] or ferrous nitrate [Fe(NO₃)₃].

Silver nitrate (AgNO₃) and TIP, which are employed for the deposition of thin films of Ag-TiO₂ with enhanced antibacterial properties, can be used.

Thiourea (CH₄N₂S) and TTIP are used for the synthesis of S-TiO₂ with visible light response and enhanced photoactivity can be used.

TBOT [Ti(OCH₂CH₂CH₂CH₃)₄] and ethanol to grow C-TiO₂ can be used for improving the rates of degradation of NOₓ in wastewater.

Sucrose (C₁₂H₂₂O₁₁) and TiCl₄ for the synthesis of doped C-TiO₂ with high electrochemical performances for sodium-ion batteries can be used.

Multifunctional (conducting and photoactive simultaneously) P-doped TiO₂ can be grown by triethyl phosphate [(C₂H₅O)₃PO] and TiCl₄.

Nickel nitrate [Ni(NO₃)₂] and TiCl₄, which can be employed synthesizing Ni-TiO₂ for photocurrent and photocatalytic applications.

Alternatively, the metal precursor can contain metallic nanoparticles of another metal in order to coat a layer of nanocomposite onto the substrate 112.

More specifically, the metallic nanoparticles can be silver, platinum or gold nanoparticles.

The metal precursor flow rate, controlled by a syringe pump (118, 218), is comprised between 0.1 and 100 µL.min⁻¹, preferentially fixed at 10 µL.min⁻¹ in order to limit the excessive formation of powders in the gas phase, which is detrimental for the thin film deposition.

The electromagnetic surface wave launcher 106 is particularly adapted for performing atmospheric pressure plasma-enhanced chemical vapour deposition (AP-PECVD) at low substrate temperature for the deposition of anatase (TiO₂) on substrates 112, said substrates 112 being one-dimensional substrates or two-dimensional substrates.

Advantageously, the substrates 112 can be heat-sensitive substrates.

One-dimensional substrates are wires, tubes, fibres, optical fibres, pipes, cables, cords, strings, ropes, filaments, threads, or ribbons.

Two-dimensional substrates are wafers, for example silicon wafers.

The substrates 112 are made of non-metallic and non-conductive materials, such as polymers and/or glass.

Figure 2 is an enlargement of the discharge tube 108. Figure 3 is a cross-section of the enlargement image of the discharge tube 108.

On the inner surface of the discharge tube 108, filamentary discharges 134 are formed. Filamentary discharge zones 136, are thus formed on the inner surface of the discharge tube 108. This phenomenon is well known from the literature (see Schlüter H. et al., Physics Reports, 2007, 443, 121-255).

The active part of the plasma close to the inner wall of the dielectric tube zones 136 has a high electron density and high ion density. This provides a high capacity of producing excited/active gaseous species. However, the active part of the plasma in the centre of the discharge tube, or central zone 138, is less reactive because of the drop of electron density and lower temperature.

The substrate 112 is introduced, directed, guided, held and/or maintained in the central zone 138 of the plasma thanks to holding means composing the substrate inlet 102 and the substrate outlet 104. The holding means are configured to hold the substrate 112 in a zone corresponding to a region located at the centre of the discharge tube 108, in particular at the centre of the central zone 138. In this way, the substrate inlet 102 and the substrate outlet 104, in particular the holding means present on said inlet 102 and said outlet 104, prevent the substrate 112 to end up in the filamentary discharge zones 136. This protects the substrates from the high temperature of these zones. This aspect is very valuable when heat-sensitive substrates 112, such as polymers and/or plastics, are to be coated.

The central zone (138) in which the (heat-sensitive) substrate 112 must be introduced, directed, guided, held and/or maintained is located at a minimal distance of 1 mm from the internal surface of said dielectric tube (108 ; 208). The maximum distance from the internal surface of said dielectric tube (108 ; 208) is 2.5 mm.

In order to ensure the adhesion of the metal oxide derivative on the substrate 112, the injection of the mist of the metal precursor is performed in the post-discharge region of the electromagnetic surface wave launcher 106 which is at a distance comprises between 0.5 cm and 20 cm from the launching gap 140, preferentially at a distance of 6 cm from the launching gap 140.

By introducing the mist of the metal precursor in the post-discharge region, not only the adhesion of the metal oxide coating onto the substrate 112 is improved, but also the density and the crystallinity of the layer is enhanced.

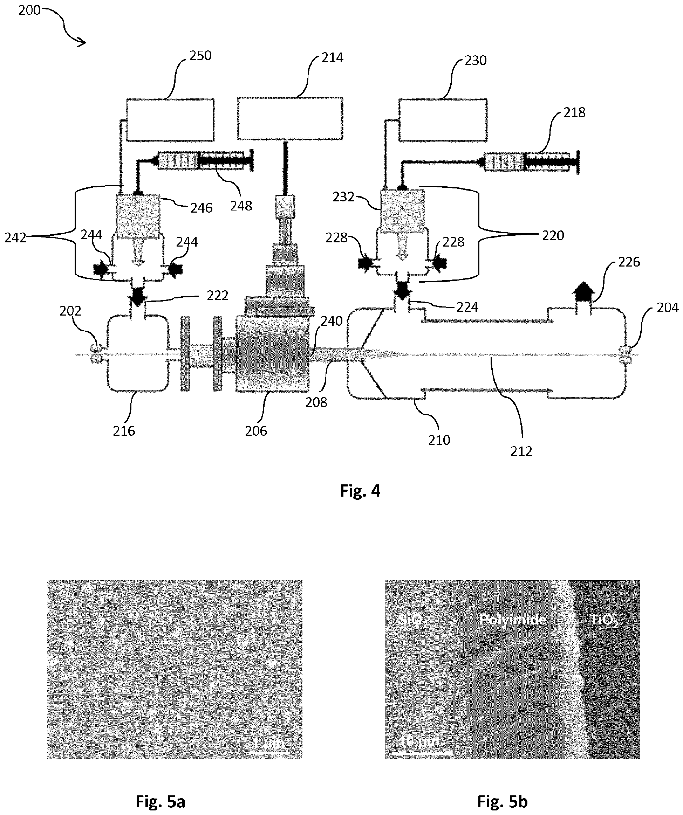

Figure 4 illustrates the second embodiment of the present invention. This figure 4 shows the numbering of the previous figure 1 for identical or similar elements, however count being incremented by 100. Specific numbers are used for the specific items for this second embodiment.

The device 200 illustrated on figure 4 is complemented by the fact that it is now possible to generate metallic nanoparticles on the surface of the substrates 212 before the coating with a metal oxide derivative in the post-discharge zone of the device 200.

The gas source 216 is connected, through the inlet 222, to nanoparticles precursor delivery system 248, preferentially set up in a syringe pump, and similar to the chemical precursor source 218. The nanoparticles precursor delivery system 248 is configured to deliver a nanoparticles precursor onto the yet non-activated surface of the substrate 212 through the inlet 222 of the gas source 216.

Said nanoparticles precursor may be under the form of a mist and/or an aerosol and/or vapour. For this, it may pass through an atomising arrangement 242, preferentially an ultrasonic system, which is located between the nanoparticles precursor delivery system 248 and the plasma gas source 216.

The ultrasonic system 242 comprises an ultrasonic nozzle 246 adapted for spraying the nanoparticles precursor into a mist and/or an aerosol that will be carried into the plasma gas source 216 and on the yet non-plasma-activated surface of the substrate 212 with carrier gases, such as argon and/or oxygen. The flow of the carrier gas is comprised between 1 and 100 slm, in general of 10 slm and is indicated by the arrows 244.

The ultrasonic system 242 is working thanks to an ultrasonic generator 250, preferentially an ultrasonic generator from Sono-Tek that operates at 120 kHz.

In this specific configuration, metallic nanoparticles are first formed in the gas phase before to cover part of the substrate 212, which is thus coated with a layer of metal oxide derivatives in an identical way that the one describe in the first embodiment of the present invention. With this specific configuration, the device 200 has subsequently two functions: generation of metallic nanoparticles and formation of nanocomposites by subsequent and/or simultaneous deposition of metal oxide derivatives. The arrangement described can be multiplied for the embedment of different nanoparticles.

It is to be noted that the different embodiments of the present invention can be combined with each other.

### Experiments

### Atmospheric pressure plasma enhanced chemical vapour deposition of anatase thin film on PMMA optical fibres at low temperature.

Titanium ethoxide (Sigma-Aldrich 80%) was used as titanium precursor. It is viscous and poorly volatile at room temperature and in order to control its flow rate with the feeding system 10, it was diluted in hexane (Sigma-Aldrich, ≥97%) to 0.4 M.

SEM (Secondary Electronic Microscopy) measurements were carried out on optical fibres coated with TiO₂. Figure 5 shows the SEM images. The top view image (figure 5a) reveals a homogeneous film with spherical shape particle of a diameter ranging between 30 and 150 nm. Film thickness is about 200 nm. The cross section image (figure 5b) reveals the homogeneous film of TiO₂ on the polyimide cladding of the silica core of the optical fibres.

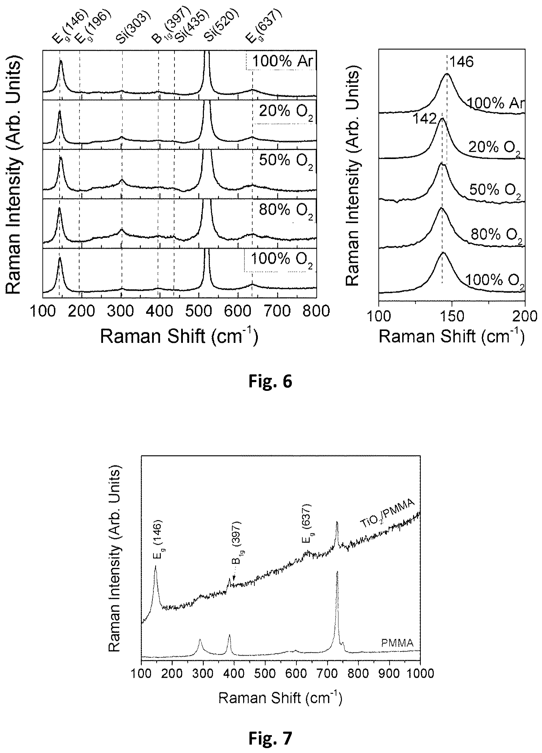

Figure 6 shows the Raman spectra of TiO₂ thin films grown on Si substrate as function of the oxygen/argon ratio. Three well defined Raman peaks at 146 cm⁻¹, 397 cm⁻¹ and 637 cm⁻¹ are observed for all the films. These peaks correspond to the *E_{g} (v6), B_{1g} (v4)* and *E_{g} (v1)* optical vibration modes and are characteristics of the anatase phase of TiO₂. The strongest *E_{g}* mode at 146 cm⁻¹ is attributed to the external vibration of the anatase structure. The Raman spectra for all samples clearly confirm that the TiO₂ coatings are in pure anatase phase.

A shift in the position of the Raman peak at 146 cm⁻¹ toward wave numbers lower than the standard peak position is observed in the Raman spectra of anatase TiO₂ grown with O₂. The blue shift and/or broadening of the lowest-frequency *E_{g}* Raman mode is usually attributed to the phonon confinement and non-stoichiometry effects in the films.

Figure 7 shows the Raman spectra of TiO₂ thin films grown on PMMA polymer optical fibre. The well-defined peaks at 146 cm⁻¹, 397 cm⁻¹ and 637 cm⁻¹ correspond to the *E_{g} (v6), B_{1g} (v4)* and *E_{g} (v1)* optical vibration modes and are characteristics of the anatase phase of TiO₂. The strongest *E_{g}* mode at 146 cm⁻¹ is attributed to the external vibration of the anatase structure. The Raman spectra clearly confirm that the TiO₂ coatings are in pure anatase phase. Peaks observed at 290, 385, 732 and 749 cm⁻¹ are all attributed to the PMMA optical fibre substrate.

### Atmospheric pressure plasma enhanced chemical vapour deposition of boron-doped anatase thin films on silicon wafer substrate at low temperature.

Titanium ethoxide (Ti(OC₂H₅)₄, 80%) was diluted in hexane (≥ 97 %) to 0.4 M. In order to facilitate the injection of the titanium precursor for the thin film deposition, the titanium precursor flow rate was fixed at 10 µL·min⁻¹ and carried toward an ultrasonic nebulizing nozzle operating at 120 kHz (Sono-Tek). The drizzle formed at the outlet of the nozzle is composed by droplets with diameters ranging between 10 µm and 20 µm and which are carried by a mixture of gases, argon/oxygen, with a flow rate of 0.9 and 1 L·min⁻¹ respectively. The boron precursor, *i.e.* boron isopropoxide (B[(CH₃)₂CHO]₃), ≥ 98 %) was placed in a separated bubbler, connected to the nebulizing nozzle, joining simultaneously the flow of Ar (carrier gas). The solution was bubbled by using a constant flow of 0.1 L·min⁻¹ of Ar, making the total flow of Ar carrier gas equal to 1 L·min⁻¹ (0.9 + 0.1 L·min⁻¹). The post-discharge distance from the launching gap was equal to 6 cm after the initiation of the plasma discharge, the deposition was carried out for 10 minutes, keeping constant all the parameters previously described. Films were grown on double side polished silicon wafer substrates (2 × 2 cm). The silicon substrates were cleaned using absolute ethanol (97 %) and dried in air prior to use. The substrate was placed in a quartz tube, along with a metallic holder, to avoid the substrate to move during the deposition.

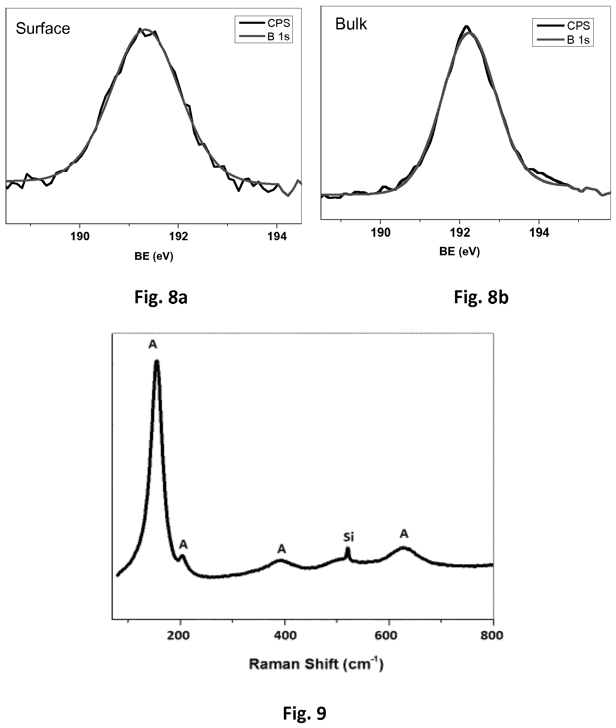

To evidence the presence of the boron in the films and elucidate its position in the film or within the TiO₂ lattice, XPS analyses were performed both on the surface (figure 8a) of the film and in depth (figure 8b). First, boron (the dopant) can be embedded either as a substitutional or interstitial dopant in the TiO₂ lattice. Generally, B 1s peaks at 190-191 eV are attributed to boron in an oxygen substitutional position and peaks in the range 191-192 eV to interstitial boron. Boron can also be found in various other forms, including cationic B³⁺ in B₂O₃ and anionic B²⁻ in TiB₂, with a characteristic B 1s peak lying at 193.1 and 187.5 eV, respectively. The peak for B 1s in our samples was found at a band energy between 191 and 192 eV (191.35 eV), meaning the dopant, *i.e.* boron, was incorporated in an interstitial position, is that to say, the film deposited is boron-doped anatase TiO₂.

To determine the crystalline phase of the TiO₂ deposited by AP-PECVD on the silicon substrate, Raman spectroscopy was carried out. Raman spectrum of the B-TiO₂ sample (figure 9), indicates the formation of anatase TiO₂.

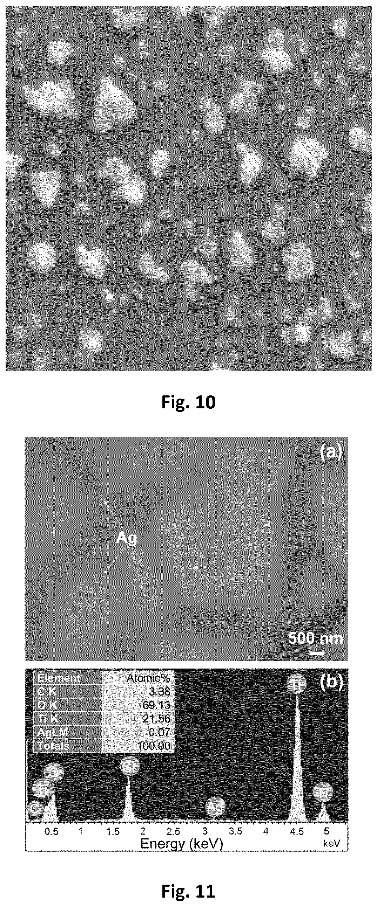

In addition, SEM analyses of the B-TiO₂ sample confirmed the deposition of the film (figure 10) on the silicon wafer substrate.

### Atmospheric pressure plasma enhanced chemical vapour deposition at low temperature of nanocomposite thin films composed of anatase and preformed silver nanoparticles

A suspension/solution composed of titanium ethoxide (Sigma-Aldrich, ≥80%) and commercial Ag nanoparticles (Ag NPs) were used to deposit Ag-TiO₂ nanocomposite films.

120 mg of commercial Ag NPs with a diameter of 6-7 nm (PlasmaChem GmbH) was dispersed in 10 mL of Hexane (Sigma-Aldrich, ≥97%) in an ultrasonic bath during 5 min. Then 500 µL of this Ag NPs suspension was added to 20 mL of a titanium ethoxide solution having a concentration of 0.5 M (the solvent is hexane) and dispersed again during 5 min. Ag NPs-titanium ethoxide suspension solution was used as a titanium precursor for Ag-TiO₂ composites coating. The titanium precursor flow rate, controlled by a syringe pump is fixed at 10 µL/min and carried toward an ultrasonic nebulizing nozzle operating at 120 kHz. The mist formed at the outlet of the nozzle is composed by droplets with diameters ranging between 10 and 20 µm. It is introduced with 2 slm argon/oxygen flow (Ar:O₂ = 1:1 slm) in the post-discharge at a distance of 6 cm from the launching gap. The discharge was generated at atmospheric pressure inside the quartz discharge tube with a MW power of 200 W and working Ar gas flow of 10 slm.

Figure 11a shows the backscattering SEM images and EDS spectrum of the Ag-TiO₂ composite coating as deposited. The top view image reveals a homogeneous film with a presence of Ag spherical shape particles and/or aggregations of nanoparticles. The presence of Ag nanoparticles in TiO₂ films was confirmed in EDS spectra (figure 11b) with an atomic ratio of 0.07 at. %.

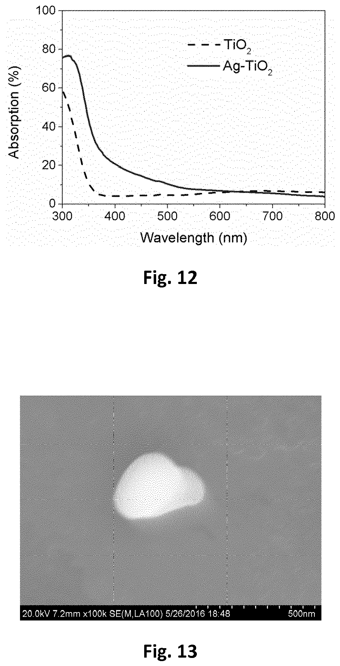

UV-Vis spectrophotometry was used to compare the optical property of the deposited Ag-TiO₂ composite coating with TiO₂ films. As observed from the spectra in figure 12, TiO₂ showed an expected strong broad absorption in UV region due to its optical band gap. However, a wide absorption band around 450 nm can be observed in the composite Ag-TiO₂ coating. This significant change is strongly acknowledged to localize surface plasmon resonance delivered by Ag NPs [K. Awazu et al., J. Am. Chem. Soc., 2008, 130, 1676-1680].

### Atmospheric pressure plasma enhanced chemical vapour deposition at low temperature of nanocomposite thin films composed of anatase and in situ synthesized silver nanoparticles.

Anatase TiO₂ thin films containing silver nanoparticles containing have been deposited using the set up described in figure 4. A liquid silver precursor is injected as a fine mist into the gas stream before the microwave discharge zone via a Sono-Tek ultrasonic nozzle. Feeding rate of the silver precursor is set up to 5 microliters/min using a syringe pump. The power delivered to the Sono-Tek is fixed at P = 1.6 W. The liquid silver precursor, nebulized into micrometer-size fine droplets, is subsequently carried to the microwave discharge by mean of a 10 slm flow of Ar carrier gas. The microwave power is set up at 200 W. As a consequence of the high plasma power density of the microwave plasma discharge, silver nanoparticles are formed in the gas phase and carried further by the plasma gas stream. The titanium precursor is injected at a flow rate of 10 µL·min⁻¹ using a syringe pump and atomized thanks to a Sono-Tek ultrasonic nozzle. The titanium precursor droplets are sent to the post discharge zone by means of a carrier gas mixture composed of 1 slm Ar and 1 slm O₂. The Sono-Tek power is set at P = 4 W. Crystalline TiO₂ thin films that entrapped the silver nanoparticles are grown on the substrate. Such procedure allows the single-step, atmospheric-pressure and low-temperature growth of anatase TiO₂ thin films loaded with Ag nanoparticles (figure 13).

By coating surfaces with crystalline metal oxide derivative, elaboration of photocatalytic surfaces is possible. Moreover, elaboration of photocatalytic surfaces on heat-sensitive material, such as glass, polymer and/or plastics is also possible. Also, the deposited crystalline thin films can be useful for photocatalytic, photovoltaic or sensing applications.

### Atmospheric pressure and low temperature growth of anatase thin films loaded with Au nanoparticles.

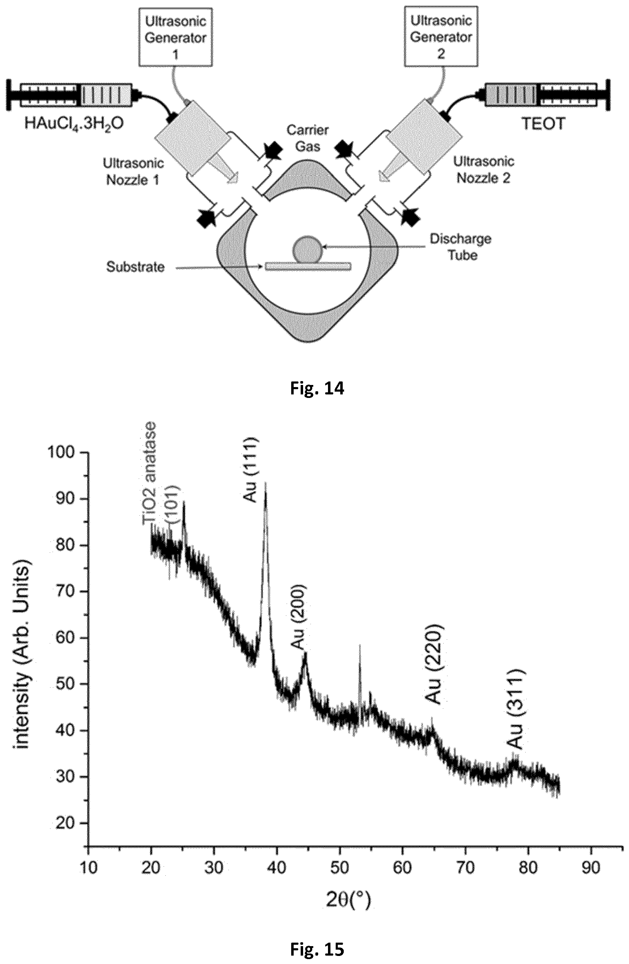

Anatase TiO₂ thin films containing gold nanoparticles also have been deposited using the set-up described in figure 14. This set-up is based on the one depicted in figure 1, except that there are two simultaneous injections systems in the post discharge area. One provides a first chemical precursor, for example a mist of TiO₂ precursor (for instance, TEOT, titanium (IV) ethoxide) while the other one provides a second chemical precursors, for example a mist of Au precursor (for instance HAuCl₄.3H₂O). The microwave power is set up at 200 W and the Ar plasma gas flow at 10 slm.

The liquid gold precursor (solution of gold trihydrochlorate solubilised in water or ethanol) is injected as a fine mist into the gas stream after the microwave discharge zone via a Sono-Tek ultrasonic nozzle. Feeding rate of the gold precursor is set up to 10 microliters/min using a syringe pump. The power delivered to the Sono-Tek is fixed at P = 2 W. The liquid gold precursor, nebulized into micrometer-size fine droplets, is subsequently carried into the microwave post-discharge by mean of a 1 slm flow of Ar carrier gas.

The titanium precursor (TEOT) is injected at a flow rate of 10 µL·min-1 using a syringe pump and atomized thanks to a Sono-Tek ultrasonic nozzle. The titanium precursor droplets are sent to the post discharge zone by means of a carrier gas mixture composed of 1 slm Ar and 1 slm O₂. The Sono-Tek power is set at P = 4 W. Crystalline TiO₂ thin films that entrapped the gold nanoparticles are grown on the substrate.

Such procedure allows the single-step, atmospheric-pressure and low-temperature growth of anatase TiO₂ thin films loaded with metallic Au NPs as shown by XRD (X-Ray Diffraction) pattern that exhibits both diffraction peaks of metallic Au and anatase TiO₂ (see figure 15).

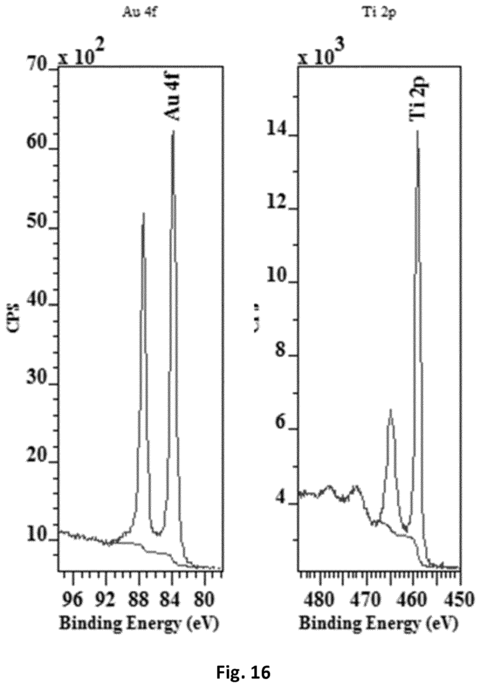

XPS measurements confirms that the coatings are only composed of metallic Au and stoichiometric TiO₂ (only Ti⁴⁺, no Ti³⁺) (see figure 16).

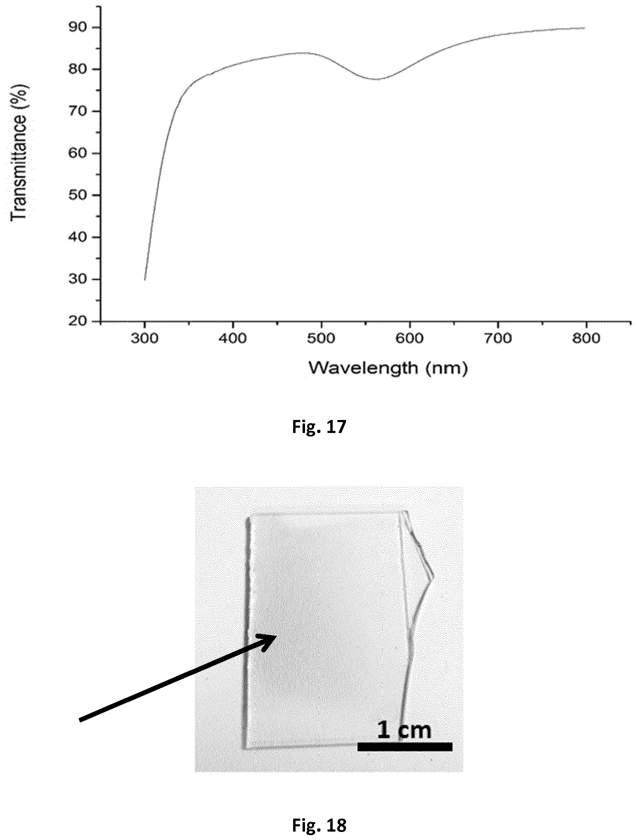

A plasmonic effect due to Au NPs is observed with a strong absorption in the range 500-600 nm (figure 17). This effect is also observed by naked eyes as the sample exhibits a pink color which is characteristic of Au NPs plasmonic effect (figure 18). The pink color is represented by the shadow area shown by the arrow on figure 18.

## Claims

1. Plasma post-discharge deposition device (100 ; 200) for depositing crystalline metal oxide derivative on a substrate (112 ; 212), said device comprising:
a) a gas source (116; 216) with a substrate inlet (102 ; 202),
b) a post-discharge deposition chamber (110 ; 210) with a substrate outlet (104 ; 204),
said substrate inlet (102 ; 202) and said substrate outlet (104 ; 204) defining a longitudinal central axis,
c) a dielectric tube (108 ; 208) placed between said gas source (116 ; 216) and said deposition chamber (110 ; 210) on said longitudinal central axis; said dielectric tube (108 ; 208) being configured to confine a plasma discharge;
wherein said dielectric tube (108 ; 208) comprises a discharge zone (136) lying on the internal surface of said dielectric tube (108 ; 208) and a central zone (138) centred on said longitudinal central axis,
said central zone (138) being located at a distance comprised between 1 mm and 2.5 mm from the internal surface of said dielectric tube (108; 208) and wherein said dielectric tube (108; 208) is surrounded by a surface wave launcher (106; 206) configured to generate the plasma discharge.

2. Plasma post-discharge deposition device (100 ; 200) according to claim 1, wherein said surface wave launcher (106; 206) is configured to provide a temperature inferior or equal to 150°C in said central zone (138), preferably a temperature inferior to 100°C..

3. Plasma post-discharge deposition device (100 ; 200) according to any one of claims 1-2, wherein said dielectric tube (108 ; 208) is a discharge tube in quartz, Pyrex™, alumina, silica, or any dielectric material, preferentially in quartz.

4. Plasma post-discharge deposition device (100 ; 200) according to claim 1, wherein said surface wave launcher (106 ; 206) is a microwave surface wave launcher with a frequency comprised between 300 MHz and 300 GHz, preferentially with a frequency of 2.45 GHz.

5. Plasma post-discharge deposition device (100 ; 200) according to any one of claims 1-4, wherein said post-discharge deposition chamber (110 ; 210) is located at a distance comprised between 0.5 cm and 20 cm from said surface wave launcher (106 ; 206), preferentially at a distance of 6 cm.

6. Plasma post-discharge deposition device (100 ; 200) according to any one of claims 1-5, wherein said gas source (116 ; 216) is configured to inject a gas into said surface wave launcher (106 ; 206), said gas being preferentially argon, helium, krypton, xenon, nitrogen, hydrogen, oxygen and/or any combination thereof.

7. Plasma post-discharge deposition device (100 ; 200) according to any one of claims 1-6, wherein said device (100 ; 200) further comprises a chemical precursor source (118 ; 218) placed in the post-discharge region of the device (100 ; 200) and configured to deliver a chemical precursor onto the plasma-activated surface of a substrate (112 ; 122), said chemical precursor being preferentially a crystalline metal oxide derivative precursor, more preferentially a crystalline metal oxide derivative precursor mixed-up with pre-formed metallic nanoparticles and/or mixed-up with a chemical precursor for doping.

8. Plasma post-discharge deposition device (100 ; 200) according to claim 7, wherein said chemical precursor source (118 ; 218) is connected to an atomising arrangement (120 ; 220) configured to deliver a chemical precursor in the form of a mist and/or an aerosol, said atomising arrangement (120; 220) being preferentially an ultrasonic system.

9. Plasma post-discharge deposition device (100 ; 200) according to any one of claims 1-8, wherein said gas source (116; 216) further comprises a metal nanoparticles precursor delivery system (248) configured to deliver metal nanoparticles precursor into said gas, said metal nanoparticles precursor being more preferentially silver, palladium, platinum or gold nanoparticles precursor.

10. Plasma post-discharge deposition device according to any one of claims 1-9, wherein said device comprises two chemical precursor sources placed in the post-discharge region of the device and configured to deliver a first chemical precursor and a second chemical precursor onto the plasma-activated surface of a substrate, said chemical precursors being preferentially titanium (IV) ethoxide and gold trihydrochlorate.

11. Plasma-enhanced chemical vapour deposition method, comprising the steps of
a) activating a substrate (112 ; 212) in a plasma post-discharge deposition device so as to produce a plasma-activated substrate;
b) functionalizing said plasma-activated substrate by a reagent in the post-discharge zone of said plasma post-discharge deposition device,
**characterized in that** said plasma post-discharge deposition device is a plasma post-discharge deposition device (100 ; 200) in accordance with any one of claims 1-10.

12. Method according to claim 11, wherein said plasma-enhanced chemical vapour deposition is carried out at atmospheric pressure and/or at a temperature which is inferior or equal to 150°C, preferably a temperature inferior to 100°C.

13. Method according to any one of claims 11-12, wherein said substrate (112 ; 212) is a heat-sensitive substrate.

14. Method according to any one of claims 11-13, wherein said substrate (112 ; 212) is a one-dimensional substrate or a two-dimensional substrate.

15. Method according to any one of claims 11-14, wherein said reagent is a crystalline metal oxide derivative, preferentially TiO₂, ZnO, WO₃, or a doped crystalline metal oxide derivative, preferentially TiO₂ doped with boron, or a mixture of metallic nanoparticles with a crystalline metal oxide derivative.

## Patentansprüche

1. Vorrichtung zur Plasmabeschichtung nach der Entladung (100, 200) zum Abscheiden eines kristallinen Metalloxidderivats auf einem Substrat (112, 212), wobei die Vorrichtung umfasst:
a) eine Gasquelle (116, 216) mit einem Substrateinlass (102, 202),
b) eine Abscheidekammer nach der Entladung (110, 210) mit einem Substratauslass (104, 204),
wobei der Substrateinlass (102, 202) und der Substratauslass (104, 204) eine Längsmittelachse definieren,
c) eine dielektrische Röhre (108, 208), die zwischen der Gasquelle (116, 216) und der Abscheidekammer (110, 210) auf der Längsmittelachse angeordnet ist, wobei die dielektrische Röhre (108, 208) konfiguriert ist, eine Plasmaentladung einzuschließen,
wobei die dielektrische Röhre (108, 208) eine Entladungszone (136), die auf der Innenfläche der dielektrischen Röhre (108, 208) liegt, und eine auf der Längsmittelachse zentrierte zentrale Zone (138) umfasst,
wobei die zentrale Zone (138) in einem Abstand zwischen 1 mm und 2,5 mm von der Innenfläche der dielektrischen Röhre (108, 208) angeordnet ist und wobei die dielektrische Röhre (108, 208) von einem Oberflächenwellenauslöser (106, 206) umgeben ist, der konfiguriert ist, die Plasmaentladung zu erzeugen.

2. Vorrichtung zur Plasmabeschichtung nach der Entladung (100, 200) nach Anspruch 1, wobei der Oberflächenwellenauslöser (106, 206) konfiguriert ist, in der zentralen Zone (138) eine Temperatur von weniger als oder gleich 150°C, vorzugsweise eine Temperatur von weniger als 100°C, bereitstellt.

3. Vorrichtung zur Plasmabeschichtung nach der Entladung (100, 200) nach einem der Ansprüche 1 bis 2, wobei die dielektrische Röhre (108, 208) eine Entladungsröhre aus Quarz, Pyrex™, Aluminiumoxid, Siliciumdioxid oder einem beliebigen dielektrischen Material, vorzugsweise aus Quarz ist.

4. Vorrichtung zur Plasmabeschichtung nach der Entladung (100, 200) nach Anspruch 1, wobei der Oberflächenwellenauslöser (106, 206) eine Mikrowellen-Oberflächenwellenauslöser mit einer Frequenz zwischen 300 MHz und 300 GHz, vorzugsweise mit einer Frequenz von 2,45 GHz ist.

5. Vorrichtung zur Plasmabeschichtung nach der Entladung (100, 200) nach einem der Ansprüche 1 bis 4, wobei die Abscheidekammer nach der Entladung (110 , 210) in einem Abstand zwischen 0,5 cm und 20 cm von dem Oberflächenwellenauslöser (106, 206), vorzugsweise in einem Abstand von 6 cm angeordnet ist.

6. Vorrichtung zur Plasmabeschichtung nach der Entladung (100, 200) nach einem der Ansprüche 1 bis 5, wobei die Gasquelle (116, 216) konfiguriert ist ein Gas in den Oberflächenwellenauslöser (106, 206) einzuspritzen, wobei das Gas vorzugsweise Argon, Helium, Krypton, Xenon, Stickstoff, Wasserstoff, Sauerstoff und/oder eine beliebige Kombination davon ist.

7. Vorrichtung zur Plasmabeschichtung nach der Entladung (100, 200) nach einem der Ansprüche 1 bis 6, wobei die Vorrichtung (100, 200) ferner eine Präkursorquelle (118, 218) umfasst, die im Nachentladungsbereich der Vorrichtung (100, 200) angeordnet und konfiguriert ist, einen Präkursor auf die plasmaaktivierte Oberfläche eines Substrats (112, 122) abzugeben, wobei der Präkursor vorzugsweise ein Präkursor eines kristallinen Metalloxidderivats, noch bevorzugter ein Präkursor eines kristallinen, mit vorgeformten metallischen Nanopartikeln vermischten Metalloxidderivats ist, der mit vermischt ist und/oder mit einem Präkursor zum Dotieren vermischt ist.

8. Vorrichtung zur Plasmabeschichtung nach der Entladung (100, 200) nach Anspruch 7,wobei die Präkursorquelle (118, 218) an eine Zerstäubungsanordnung (120, 220) angeschlossen ist, die konfiguriert ist, einen Präkursor in Form eines Nebels und/oder eines Aerosols abzugeben, wobei die Zerstäubungsanordnung (120, 220) vorzugsweise ein Ultraschallsystem ist.

9. Vorrichtung zur Plasmabeschichtung nach der Entladung (100, 200) nach einem der Ansprüche 1 bis 8, wobei die Gasquelle (116, 216) ferner ein Abgabesystem für Metallnanopartikeln-Präkursoren (248) umfasst, konfiguriert Metallnanopartikel-Präkursoren in das Gas abzugeben, wobei der Metallnanopartikel-Präkursor bevorzugter ein Präkursor von Silber-, Palladium-, Platin- oder Goldnanopartikeln ist.

10. Vorrichtung zur Plasmabeschichtung nach der Entladung (100, 200) nach einem der Ansprüche 1 bis 9, wobei die Vorrichtung zwei Präkursorquellen umfasst, die im Nachentladungsbereich der Vorrichtung angeordnet und konfiguriert sind, einen ersten Präkursor und einen zweiten Präkursor auf die plasmaaktivierte Oberfläche eines Substrats abzugeben, wobei die Präkursoren vorzugsweise Titan(IV)-Ethoxid und Goldtrihydrochlorat sind.

11. Plasmagestütztes chemisches Gasphasenabscheidungsverfahren, die folgenden Schritte umfassend
a) Aktivieren eines Substrats (112, 212) in einer Vorrichtung zur Plasmabeschichtung nach der Entladung, um ein plasmaaktiviertes Substrat zu erzeugen,
b) Funktionalisieren des plasmaaktivierten Substrats durch ein Reagens in der Nachentladungszone der Vorrichtung zur Plasmabeschichtung nach der Entladung
**dadurch gekennzeichnet, dass** die Vorrichtung zur Plasmabeschichtung nach der Entladung eine Vorrichtung zur Plasmabeschichtung nach der Entladung (100, 200) gemäß einem der Ansprüche 1 bis 10 ist.

12. Verfahren nach Anspruch 11, wobei die plasmagestützte chemische Gasphasenabscheidung bei Atmosphärendruck und/oder bei einer Temperatur von weniger als oder gleich 150 °C, vorzugsweise bei einer Temperatur von weniger als 100 °C, durchgeführt wird.

13. Verfahren nach einem der Ansprüche 11 bis 12, wobei das Substrat (112, 212) ein wärmeempfindliches Substrat ist.

14. Verfahren nach einem der Ansprüche 11 bis 13, wobei das Substrat (112, 212) ein eindimensionales Substrat oder ein zweidimensionales Substrat ist.

15. Verfahren nach einem der Ansprüche 11 bis 14, wobei das Reagens ein kristallines Metalloxidderivat, vorzugsweise TiO₂, ZnO, WO₃, oder ein dotiertes kristallines Metalloxidderivat, vorzugsweise mit Bor dotiertes TiO₂, oder eine Mischung von metallischen Nanopartikeln mit einem kristallinen Metalloxidderivat ist.

## Revendications

1. Dispositif de dépôt d'une post-décharge par plasma (100 ; 200) pour le dépôt d'un dérivé cristallin d'oxyde métallique sur un substrat (112 ; 212), le dispositif en question comprenant :
a) une source de gaz (116 ; 216) qui comprend une entrée (102 ; 202) pour le substrat ;
b) une chambre de dépôt de post-décharge (110 ; 210) qui comprend une sortie (104 ; 204) pour le substrat ; ladite entrée (102 ; 202) pour le substrat et ladite sortie (104 ; 204) pour le substrat définissant un axe central longitudinal ;
c) un tube diélectrique (108 ; 208) qui est placé entre ladite source de gaz (116; 216) et ladite chambre de dépôt (110; 210) sur ledit axe central longitudinal; ledit tube diélectrique (108 ; 208) étant configuré pour confiner une décharge de plasma ;
dans lequel ledit tube diélectrique (108 ; 208) comprend une zone de décharge qui est située sur la surface interne dudit tube diélectrique (108 ; 208) et une zone centrale (138) qui est centrée sur ledit axe central longitudinal ;
ladite zone centrale (138) étant disposée à une distance qui est comprise entre 1 mm et 2,5 mm par rapport à la surface interne dudit tube diélectrique (108 ; 208) ; et dans lequel ledit tube diélectrique (108 ; 208) est entouré par un lanceur d'ondes de surface (106 ; 206) qui est configuré pour générer la décharge de plasma.

2. Dispositif de dépôt d'une post-décharge par plasma (100 ; 200) selon la revendication 1, dans lequel ledit lanceur d'ondes de surface (106; 206) est configuré pour procurer une température qui est inférieure ou égale à 150 °C dans ladite zone centrale (138), de préférence une température qui est inférieure à 100 °C.

3. Dispositif de dépôt d'une post-décharge par plasma (100 ; 200) selon l'une quelconque des revendications 1 à 2, dans lequel ledit tube diélectrique (108; 208) représente un tube de décharge en quartz, en pyrex™, en alumine, en silice ou en n'importe quel matériau diélectrique, de manière préférentielle en quartz.

4. Dispositif de dépôt d'une post-décharge par plasma (100 ; 200) selon la revendication 1, dans lequel ledit lanceur d'ondes de surface (106 ; 206) représente un lanceur d'ondes de surface sous la forme de micro-ondes avec une fréquence qui est comprise entre 300 MHz et 300 GHz, de manière préférentielle avec une fréquence de 2,45 GHz.

5. Dispositif de dépôt d'une post-décharge par plasma (100 ; 200) selon l'une quelconque des revendications 1 à 4, dans lequel ladite chambre de dépôt de post-décharge (110; 210) est située à une distance qui est comprise entre 0,5 cm et 20 cm par rapport audit lanceur d'ondes de surface (106 ; 206), de manière préférentielle à une distance de 6 cm.

6. Dispositif de dépôt d'une post-décharge par plasma (100 ; 200) selon l'une quelconque des revendications 1 à 5, dans lequel ladite source de gaz (116 ; 216) est configurée pour injecter un gaz dans ledit lanceur d'ondes de surface (106; 206), le gaz en question représentant de manière préférentielle de l'argon, de l'hélium, du krypton, du xénon, de l'azote, de l'hydrogène, de l'oxygène et/ou l'une quelconque de leurs combinaisons.

7. Dispositif de dépôt d'une post-décharge par plasma (100 ; 200) selon l'une quelconque des revendications 1 à 6, dans lequel le dispositif en question (100 ; 200) comprend en outre une source d'un précurseur de produit chimique (118 ; 218) qui est placée dans la zone de post-décharge du dispositif (100 ; 200) et qui est configurée pour distribuer un précurseur de produit chimique sur la surface d'un substrat (112 ; 122) qui est activée par le plasma, ledit précurseur de produit chimique représentant de manière préférentielle un précurseur d'un dérivé cristallin d'un oxyde métallique, de manière plus préférée un précurseur d'un dérivé cristallin d'un oxyde métallique en mélange avec des nanoparticules métalliques préformées et/ou en mélange avec un précurseur de produit chimique destiné au dopage.

8. Dispositif de dépôt d'une post-décharge par plasma (100 ; 200) selon la revendication 7, dans lequel ladite source d'un précurseur de produit chimique (118; 218) est raccordée à un agencement d'atomisation (120; 220) qui est configuré pour distribuer un précurseur de produit chimique sous la forme d'un brouillard et/ou d'un aérosol, ledit agencement d'atomisation (120 ; 220) représentant de manière préférentielle un système à ultrasons.

9. Dispositif de dépôt d'une post-décharge par plasma (100 ; 200) selon l'une quelconque des revendications 1 à 8, dans lequel ladite source de gaz (116; 216) comprend en outre un système de distribution d'un précurseur de nanoparticules métalliques (248) qui est configuré pour distribuer un précurseur de nanoparticules métalliques dans ledit gaz, ledit précurseur de nanoparticules métalliques représentant de manière plus préférée un précurseur de nanoparticules d'argent, de palladium, de platine ou d'or.

10. Dispositif de dépôt d'une post-décharge par plasma (100 ; 200) selon l'une quelconque des revendications 1 à 9, dans lequel le dispositif en question comprend deux sources de précurseurs de produits chimiques qui sont placées dans la zone de post-décharge du dispositif et qui sont configurées pour distribuer un premier précurseur de produit chimique et un deuxième précurseur de produit chimique sur la surface d'un substrat, activée par plasma, lesdits précurseurs de produits chimiques représentant de manière préférentielle l'éthoxyde de titane(IV) et le trichlorhydrate d'or.

11. Procédé de dépôt chimique en phase vapeur amplifié par plasma, comprenant les étapes dans lesquelles :
a) on active un substrat (112; 122) dans un dispositif de dépôt d'une post-décharge par plasma dans le but d'obtenir un substrat activé par plasma ;
b) on fonctionnalise ledit substrat activé par plasma par l'intermédiaire d'un réactif dans la zone de post-décharge dudit dispositif de dépôt d'une post-décharge par plasma ;
**caractérisé en ce que** ledit dispositif de dépôt d'une post-décharge par plasma représente un dispositif de dépôt d'une post-décharge par plasma (100 ; 200) selon l'une quelconque des revendications 1 à 10.

12. Procédé selon la revendication 11, dans lequel ledit dépôt chimique en phase vapeur amplifié par plasma est mis en œuvre sous pression atmosphérique et/ou à une température qui est inférieure ou égale à 150 °C, de préférence à une température qui est inférieure à 100 °C.

13. Selon l'une quelconque des revendications 11 à 12, dans lequel ledit substrat (112 ; 212) représente un substrat qui est sensible à la chaleur.

14. Selon l'une quelconque des revendications 11 à 13, dans lequel ledit substrat (112 ; 212) représente un substrat unidimensionnel ou un substrat bidimensionnel.

15. Selon l'une quelconque des revendications 11 à 14, dans lequel ledit réactif représente un dérivé cristallin d'un oxyde métallique, de manière préférentielle du TiO₂, du ZnO, du WO₃, ou un dérivé cristallin dopé d'un oxyde métallique, de manière préférentielle du TiO₂ qui est dopé avec du bore, ou un mélange de nanoparticules métalliques avec un dérivé cristallin d'un oxyde métallique.
